# FASCICULE DE BREVET EUROPEEN

(11) **EP 3 859 800 B1**
(45) Date de publication et mention de la délivrance du brevet: **15.02.2023**
(21) Numéro de dépôt: 21161536.4
(22) Date de dépôt: 26.06.2017
(51) Int. Cl.: H01L 41/08, H03H 9/02, H03H 9/25, H01L 41/312, H01L 41/313

(54) **STRUCTURE HYBRIDE POUR DISPOSITIF A ONDES ACOUSTIQUES DE SURFACE**
HYBRIDSTRUKTUR FÜR VORRICHTUNG MIT OBERFLÄCHENSCHALLWELLEN
HYBRID STRUCTURE FOR A DEVICE WITH SURFACE ACOUSTIC WAVES

(30) Priorité: 30.06.2016 FR 1656191
(43) Date de publication de la demande: 04.08.2021
(62) Demande divisionnaire de: 20165678.2
(73) Titulaire: SOITEC, 38190 Bernin (FR)
(72) Inventeur: GAUDIN, Gweltaz, 38920 CROLLES (FR); HUYET, Isabelle, 38920 CROLLES (FR)
(74) Mandataire: IP Trust

(56) Documents cités:
- WO-A1-2016/087728
- DE-A1-102004 045 181
- US-A1- 2007 032 040

## Description

### DOMAINE DE L'INVENTION

La présente invention concerne le domaine des dispositifs à ondes acoustiques de surface. Elle concerne en particulier une structure hybride adaptée pour la fabrication de dispositifs à ondes acoustiques de surface et un procédé de fabrication de ladite structure hybride.

### ARRIERE PLAN TECHNOLOGIQUE DE L'INVENTION

Les dispositifs à ondes acoustiques de surface (« SAW » pour « Surface Acoustic Wave » selon la terminologie anglo-saxonne) utilisent un ou plusieurs transducteurs interdigités élaborés sur un substrat piézoélectrique pour convertir des signaux électriques en ondes acoustiques et vice versa. De tels dispositifs ou résonateurs SAW sont souvent utilisés dans les applications de filtrage. La technologie SAW à radiofréquences (RF) sur substrat piézoélectrique fournit d'excellentes performances telles qu'une haute isolation et de faibles pertes d'insertion. Pour cette raison, elle est utilisée pour les duplexeurs RF dans les applications de communication sans fil. Néanmoins, pour être plus concurrentiels par rapport aux duplexeurs RF basés sur la technologie des ondes acoustiques de volume (« BAW » pour « Bulk Acoustic Wave »), les dispositifs SAW RF requièrent que la stabilité en température de leur réponse en fréquence soit améliorée.

La dépendance de la fréquence de fonctionnement des dispositifs SAW vis-à-vis de la température, ou le coefficient de fréquence thermique (« TCF » pour « Température Coefficient of Frequency »), dépend d'une part des variations de l'espacement entre les électrodes interdigitées des transducteurs, qui sont généralement dues aux coefficients de dilatation thermique (« CTE » pour « Coefficient of Thermal Expansion ») relativement élevés des substrats piézoélectriques utilisés ; d'autre part, le TCF dépend du coefficient de vitesse thermique car la dilatation ou la contraction du substrat piézoélectrique s'accompagne d'une augmentation ou d'une diminution de la vitesse de l'onde acoustique de surface. Pour minimiser le coefficient de fréquence thermique (TCF), un objectif est donc de minimiser la dilatation/contraction du substrat piézoélectrique, notamment dans la zone de surface dans laquelle les ondes acoustiques vont se propager.

L'article de K.Hashimoto, M.Kadota et al, « Recent development of température compensated SAW devices », IEEE Ultrason. Symp. 2011, pages 79 à 86, 2011, donne une vue d'ensemble des approches couramment utilisées pour surmonter le problème de dépendance vis-à-vis de la température de la réponse en fréquence des dispositifs SAW.

Une approche consiste à utiliser un substrat hybride, par exemple composé d'une couche de matériau piézoélectrique disposée sur un substrat de silicium. Le CTE faible du silicium permet de limiter la dilatation/contraction de la couche piézoélectrique en température. Dans le cas d'une couche piézoélectrique de Tantalate de Lithium (LiTaO3), l'article précédemment cité indique qu'un ratio de 10 entre l'épaisseur de LiTaO3 et l'épaisseur du substrat de silicium permet d'améliorer convenablement le coefficient de fréquence thermique (TCF).

Le document DE102004045181 divulgue également une structure adaptée aux applications SAW, comprenant une couche piézoélectrique disposée sur une couche de compensation (par exemple Silicium).

L'un des inconvénients d'un tel substrat hybride vient de la présence d'ondes acoustiques parasites (appelées « spurious acoustic modes » dans l'article « Characterization of bonded wafer for RF filters with reduced TCF », B.P.Abbott et al, Proc 2005 IEEE International Ultrasonics Symposium, Sept 19-21, 2005, pp.926-929) qui impactent négativement les caractéristiques en fréquence du résonateur élaboré sur le substrat hybride. Ces résonances parasites sont notamment liées à des réflexions parasites sur les interfaces sous-jacentes, dont notamment l'interface entre le LiTaO3 et le silicium. Une solution pour diminuer ces résonances parasites est d'augmenter l'épaisseur de la couche de LiTaO3 ; cela supposant d'augmenter également l'épaisseur du substrat de Si pour conserver les améliorations du TCF, l'épaisseur totale du substrat hybride n'est alors plus compatible avec les besoins de réduction d'épaisseur des composants finaux, notamment pour adresser le marché des téléphones cellulaires. Une autre solution, proposée par K.Hashimoto est de rugosifier la surface inférieure de la couche de LiTaO3 de façon à limiter les réflexions de l'onde acoustique sur celle-ci. Une telle rugosification représente une difficulté à gérer quand un procédé de collage direct, requérant des surfaces à assembler très lisses, est utilisé pour la réalisation du substrat hybride.

Un autre inconvénient d'un substrat hybride selon l'état de l'art vient de la présence du support en matériau silicium semi-conducteur, qui même fortement résistif, est susceptible de contenir des charges mobiles et d'impacter les performances du dispositif, notamment en augmentant les pertes d'insertion et les distorsions (linéarité) du signal RF par rapport à un substrat massif piézoélectrique.

Pour améliorer les performances des dispositifs radiofréquences, le document WO2016/087728 propose une structure comprenant une couche de piégeage caractérisée par une densité de défauts spécifique, disposée sur le substrat support.

### OBJET DE L'INVENTION

Un objet de la présente invention est de remédier à tout ou partie des inconvénients de l'art antérieur. Un objet de l'invention est de proposer une structure hybride permettant la réduction et/ou l'élimination desdites ondes acoustiques parasites et assurant une performance stable pour des dispositifs fonctionnant à hautes fréquences.

### BREVE DESCRIPTION DE L'INVENTION

La présente invention concerne une structure hybride pour dispositif à ondes acoustiques de surface comprenant une couche utile de matériau piézoélectrique présentant une première face libre et une deuxième face disposée sur un substrat support dont le coefficient de dilatation thermique est inférieur à celui de la couche utile, la structure hybride étant caractérisée en ce qu'elle comprend :
- une couche de piégeage interposée entre la couche utile et le substrat support ;
- au moins une interface fonctionnelle de rugosité déterminée entre la couche utile et la couche de piégeage.

La couche de piégeage de la structure hybride selon l'invention piège efficacement les charges électriques mobiles potentiellement générées dans le substrat support lors du fonctionnement du dispositif SAW RF élaboré sur ladite structure hybride. Les performances RF (linéarité, pertes d'insertion) atteignent ainsi un bon niveau, comparable voire supérieur à celui des technologies sur substrats piézoélectriques massifs.

L'interface fonctionnelle de rugosité déterminée permet une diffusion efficace des ondes acoustiques susceptibles de se propager en profondeur dans la couche utile, évitant ainsi leurs réflexions parasites qui sont connues pour impacter négativement la qualité du signal du dispositif SAW. Cette diffusion des ondes acoustiques est rendue plus efficace du fait que l'interface fonctionnelle soit localisée entre la couche utile et la couche de piégeage : en effet, outre ses qualités de piégeage de charges mobiles, la couche de piégeage permet d'écranter efficacement l'interface sous-jacente avec le substrat support, cette dernière contribuant dans les structures hybrides à réfléchir des ondes acoustiques.

Selon des caractéristiques avantageuses de l'invention, prises seules ou en combinaison :
- la couche de piégeage est directement en contact avec le substrat support ;
- la couche de piégeage est formée d'un matériau choisi parmi le silicium amorphe, le silicium poly-cristallin, le germanium amorphe ou poly-cristallin ;
- la couche de piégeage est formée par implantation dans une couche superficielle du substrat support ou par gravure et structuration de la couche superficielle du substrat support ;
- la rugosité déterminée de l'interface fonctionnelle présente une amplitude crête à creux supérieure à 0,3 µm, avantageusement supérieure ou égale à 0,5 µm, voire à 1 µm ;
- l'interface fonctionnelle est formée par l'interface entre la couche utile et la couche de piégeage, la deuxième face de la couche utile présentant la rugosité déterminée ;
- l'interface fonctionnelle est formée par l'interface entre une première couche intercalaire, disposée sur la deuxième face de la couche utile, et la couche de piégeage ; la couche de piégeage présentant la rugosité déterminée ;
- la première couche intercalaire comprend un matériau choisi parmi l'oxyde de silicium, le nitrure de silicium, l'oxynitrure de silicium, un matériau de même nature que celui constituant la couche utile ;
- la structure hybride comprend une deuxième interface fonctionnelle ;
- la deuxième interface fonctionnelle est formée par l'interface entre la couche utile et une deuxième couche intercalaire disposée sur la première couche intercalaire, la deuxième interface fonctionnelle présentant une deuxième rugosité déterminée dont l'amplitude crête-à-creux est supérieure à 0,1 µm ;
- la deuxième couche intercalaire comprend un matériau choisi parmi l'oxyde de silicium, le nitrure de silicium, l'oxynitrure de silicium, un matériau de même nature que celui constituant la couche utile ;
- la première couche intercalaire et la deuxième couche intercalaire sont formées du même matériau ;
- la couche utile comprend un matériau piézoélectrique choisi parmi le tantalate de lithium (LiTaO3), le niobate de lithium (LiNbO3), le quartz, l'oxyde de zinc (ZnO), le nitrure d'aluminium (AlN) ;
- le substrat support est un substrat massif ou un substrat composite comprenant au moins une couche vierge ou comportant tout ou partie de composants micro-électroniques.

La présente invention concerne également un dispositif à ondes acoustiques de surface comprenant une structure hybride telle que ci-dessus.

La présente invention concerne en outre un procédé de fabrication d'une structure hybride pour un dispositif à ondes acoustiques de surface comprenant :
- Une étape de fourniture d'une couche utile de matériau piézoélectrique comprenant une première face et une deuxième face présentant une rugosité déterminée ;
- Une étape de fourniture d'un substrat support présentant un coefficient de dilatation thermique inférieur à celui de la couche utile ;
- Une étape d'assemblage pour disposer la couche utile sur le substrat support ;

Le procédé est remarquable en ce qu'il comprend, préalablement à l'étape d'assemblage, une étape de formation d'une couche de piégeage sur la deuxième face de la couche utile, l'interface entre la couche de piégeage et la couche utile formant une interface fonctionnelle de rugosité déterminée ; l'étape d'assemblage s'opère entre la couche de piégeage et le substrat support.

La présente invention concerne également un autre procédé de fabrication d'une structure hybride pour un dispositif à ondes acoustiques de surface comprenant :
- Une étape de fourniture d'une couche utile de matériau piézoélectrique comprenant une première face et une deuxième face ;
- Une étape de fourniture d'un substrat support présentant un coefficient de dilatation thermique inférieur à celui de la couche utile ;
- Une étape d'assemblage pour disposer la couche utile sur le substrat support ;
Le procédé est remarquable en ce qu'il comprend, préalablement à l'étape d'assemblage :
- Une étape de formation d'une couche de piégeage, présentant une rugosité déterminée, sur le substrat support ;
- Une étape de formation d'une première couche intercalaire sur la couche de piégeage, l'interface entre la couche de piégeage et la première couche intercalaire formant une interface fonctionnelle de rugosité déterminée.

Selon des caractéristiques avantageuses de ce procédé de fabrication, prises seules ou en combinaison :
- la rugosité déterminée de l'interface fonctionnelle présente une amplitude crête à creux supérieure à 0,3 µm, avantageusement supérieure ou égale à 0,5 µm, voire à 1 µm ;
- l'étape d'assemblage s'opère entre la première couche intercalaire et la deuxième face de la couche utile ;
- le procédé de fabrication d'une structure hybride comprend, préalablement à l'étape d'assemblage, une étape de formation d'une deuxième couche intercalaire sur la deuxième face de la couche utile qui présente une deuxième rugosité déterminée, l'étape d'assemblage s'opérant entre la première couche intercalaire et la deuxième couche intercalaire ; l'interface entre la couche utile et la deuxième couche intercalaire forme une deuxième interface fonctionnelle.

### BREVE DESCRIPTION DES DESSINS

D'autres caractéristiques et avantages de l'invention ressortiront de la description détaillée qui va suivre en référence aux figures annexées sur lesquelles :
- les figures 1 à 3 présentent des structures hybrides conformes à l'invention ;
- la figure 4 présente un dispositif à ondes acoustiques de surface conforme à l'invention ;
- les figures 5a à 5e, 6a à 6e et 7a à 7e présentent des procédés de fabrication de structures hybrides, conformes à l'invention.

### DESCRIPTION DETAILLEE DE L'INVENTION

Dans la partie descriptive, les mêmes références sur les figures pourront être utilisées pour des éléments de même nature.

Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y.

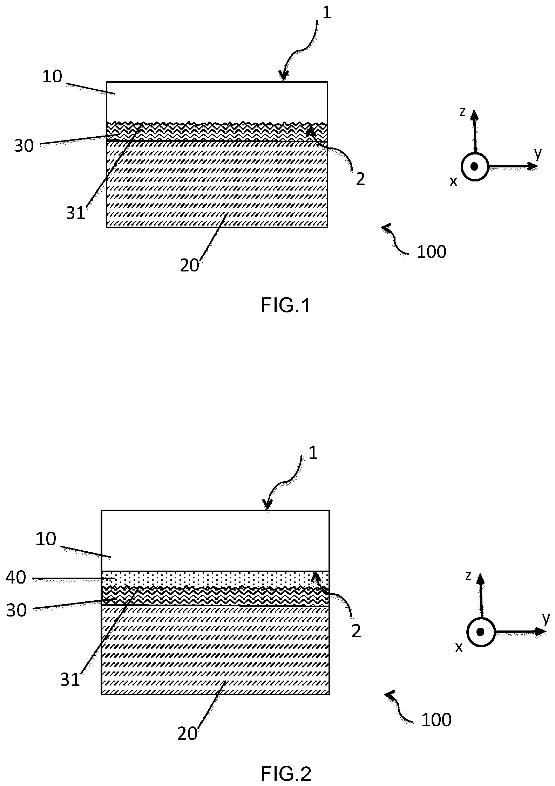

Comme illustré sur la figure 1, l'invention concerne une structure hybride 100 pour dispositif à ondes acoustiques de surface comprenant une couche utile 10 de matériau piézoélectrique présentant une première face 1 libre et une deuxième face 2. La couche utile 10 comprend un matériau piézoélectrique choisi, à titre d'exemple, parmi le tantalate de lithium (LiTaO3), le niobate de lithium (LiNbO3), le quartz, l'oxyde de zinc (ZnO), le nitrure d'aluminium (AlN).

La couche utile 10 est disposée sur un substrat support 20 dont le coefficient de dilatation thermique est inférieur à celui de la couche utile 10. Le substrat support 20 est, à titre d'exemple, formé en silicium ou en germanium.

La structure hybride 100 selon l'invention comprend également une couche de piégeage 30 interposée entre la couche utile 10 et le substrat support 20. Par couche de piégeage, on entend une couche apte à piéger les charges électriques mobiles susceptibles d'être présentes dans le substrat support 20. A titre d'exemple, la couche de piégeage 30 est formée d'un matériau choisi parmi le silicium amorphe, le silicium poly-cristallin, le germanium amorphe ou poly-cristallin. La couche de piégeage 30 pourra également être formée par une technique ou une combinaison de techniques parmi lesquelles :
- l'implantation d'ions dans une couche superficielle du substrat support 20 ; pour un substrat en silicium, une implantation par exemple d'ions d'argon, de silicium ou d'azote pourra être effectuée pour générer une couche superficielle perturbée, apte à piéger des charges mobiles issues du substrat support 20 ;
- ou par la gravure et la structuration d'une couche superficielle du substrat support 20 ; par exemple, par gravure mécanique, chimique humide ou sèche, induisant une structuration de la surface, site privilégié de piégeage pour des charges mobiles issues du substrat support 20.

L'épaisseur de la couche de piégeage 30 pourra être comprise entre quelques dizaines de nm et quelques µm, voire quelques dizaines de µm .

Avantageusement, la couche de piégeage 30 est directement en contact avec le substrat support 20, ce qui permet un piégeage efficace des charges mobiles générées dans le substrat support 20.

La structure hybride 100 selon l'invention comprend en outre au moins une interface fonctionnelle 31 de rugosité déterminée entre la couche utile 10 et la couche de piégeage 30. La rugosité de l'interface fonctionnelle 31 est définie par l'amplitude maximale crête-à-creux, mesurée par exemple par profilométrie mécanique ou optique, sur des profils de mesure de l'ordre de 50 à 500 µm ou des surfaces de mesure de l'ordre de 50x50 à 500x500 µm2. Avantageusement, la rugosité déterminée crête-à-creux est supérieure à 0,3 µm. Avantageusement, elle est même supérieure ou égale à 0,5 µm, voire à 1 µm. Elle est préférentiellement comprise entre 0,3 et 5 µm.

De manière également avantageusement, la densité spectrale (PSD) de la rugosité de l'interface fonctionnelle 31 couvre tout ou partie de la bande spectrale de longueurs d'onde des ondes parasites que l'on cherche à éliminer. Préférentiellement, la rugosité déterminée présente des longueurs d'ondes spatiales et une amplitude au moins égales à un quart des longueurs d'ondes parasites.

La rugosité déterminée de l'interface fonctionnelle 31 pourra donc être adaptée en amplitude et potentiellement en densité spectrale en fonction de la fréquence des ondes acoustiques du dispositif SAW qui sera fabriqué sur la structure hybride 100, pour son aptitude à diffuser efficacement les ondes acoustiques susceptibles de se propager dans la couche utile 10.

La couche de piégeage 30 de la structure hybride 100 selon l'invention piège efficacement les charges électriques mobiles potentiellement générées dans le substrat support 20 lors du fonctionnement du dispositif SAW RF élaboré sur la première face 1 de ladite structure hybride 100. Les performances RF (linéarité, pertes d'insertion) atteignent ainsi un très bon niveau, comparable voire supérieur à celui des technologies sur substrats piézoélectriques massifs.

L'interface fonctionnelle 31 de rugosité déterminée permet une diffusion efficace des ondes acoustiques susceptibles de se propager en profondeur dans la couche utile 10, évitant ainsi leurs réflexions parasites, qui sont connues pour impacter négativement la qualité du signal du dispositif SAW.

Selon un premier mode de réalisation, illustré sur la figure 1, l'interface fonctionnelle 31 est formée par l'interface entre la couche utile 10 et la couche de piégeage 30.

Selon un deuxième mode de réalisation, illustré sur la figure 2, l'interface fonctionnelle 31 est formée par l'interface entre une première couche intercalaire 40, disposée sur la deuxième face 2 de la couche utile 10, et la couche de piégeage 30. A titre d'exemple, la première couche intercalaire 40 peut comprendre un matériau choisi parmi l'oxyde de silicium, le nitrure de silicium, l'oxynitrure de silicium ou encore un matériau de même nature que la couche utile.

Ces deux modes de réalisation sont avantageux en ce que la couche de piégeage 30 permet d'éloigner et d'écranter l'interface sous-jacente avec le substrat support 20, cette dernière étant un fort contributeur, dans les structures hybrides habituelles, à la réflexion des ondes acoustiques se propageant dans le volume de la couche utile 10. L'interface avec le substrat support 20 est écrantée dans le sens où la majorité, voire la totalité, des ondes acoustiques atteignant l'interface fonctionnelle 31 vont être diffusée efficacement par cette dernière et ainsi ne jamais atteindre cette interface.

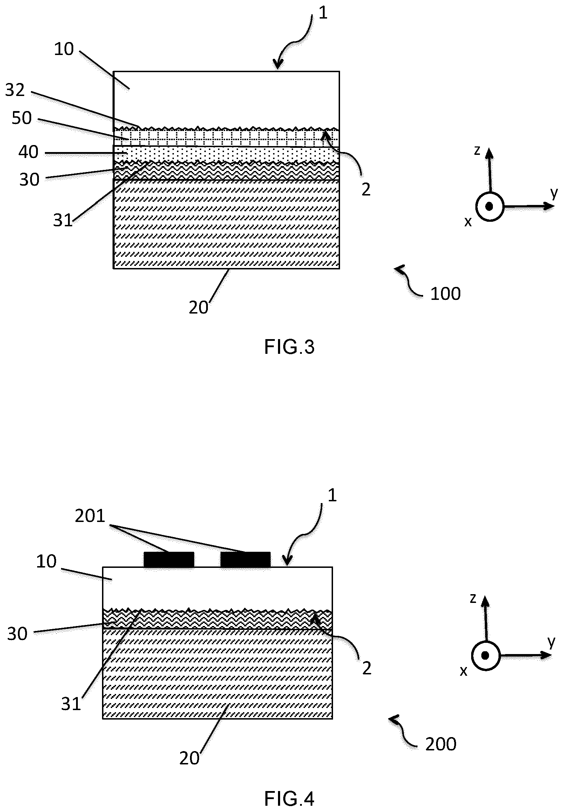

Selon un troisième mode de réalisation, illustré sur la figure 3, la structure hybride 100 comprend une deuxième interface fonctionnelle 32 présentant une deuxième rugosité déterminée, dont l'amplitude crête-à-creux est supérieure à 0,1 µm.

Elle est préférentiellement comprise entre 0,1 et 5 µm. . Notons que la deuxième interface fonctionnelle 32 pourra présenter une deuxième rugosité déterminée différente de la rugosité déterminée de la première interface fonctionnelle 31, tant en amplitude qu'en densité spectrale. Avantageusement, les densités spectrales pourront être choisies pour couvrir de manière complémentaire la bande spectrale de longueurs d'onde des ondes parasites que l'on souhaite éliminer.

La deuxième interface fonctionnelle 32 est formée par l'interface entre la couche utile 10 et une deuxième couche intercalaire 50 disposée sur la première couche intercalaire 40. A titre d'exemple, la deuxième couche intercalaire 50 comprend un matériau choisi parmi l'oxyde de silicium, le nitrure de silicium, l'oxynitrure de silicium ; elle peut également comprendre un matériau de même nature que celui constituant la couche utile 10 : pour une couche utile 10 en LiTaO3, la deuxième couche intercalaire 50 pourra par exemple consister en une couche de LiTaO3 amorphe déposée.

Selon une variante avantageuse de ce troisième mode de réalisation, les première 40 et deuxième 50 couches intercalaires sont formées du même matériau ; ainsi, l'interface entre ces deux couches ne contribue pas ou peu à des réflexions parasites, du fait de l'absence de différence d'impédance acoustique entre les deux couches.

Dans les différents modes de réalisation décrits, le substrat support est un substrat massif. Alternativement, il pourra consister en un substrat composite comprenant au moins une couche vierge ou une couche structurée, comportant tout ou partie de composants micro-électroniques ; ces configurations sont particulièrement avantageuses pour réaliser des systèmes co-intégrés, incluant des dispositifs à ondes acoustiques de surface dans et sur la couche utile 10, et des composants (commutateurs, amplificateurs, autres filtres...) dans le substrat support.

L'invention concerne également un dispositif à ondes acoustiques de surface 200 comprenant une structure hybride 100, illustré en figure 4. Le dispositif 200 comprend par exemple des électrodes métalliques interdigitées 201 sur la première face 1 de la couche utile 10, entre lesquelles se propagera l'onde acoustique.

La structure hybride 100 est particulièrement adaptée pour la fabrication de dispositifs à ondes acoustiques de surface 200 utilisant des fréquences d'ondes acoustiques comprises entre 700MHz et 3GHz.

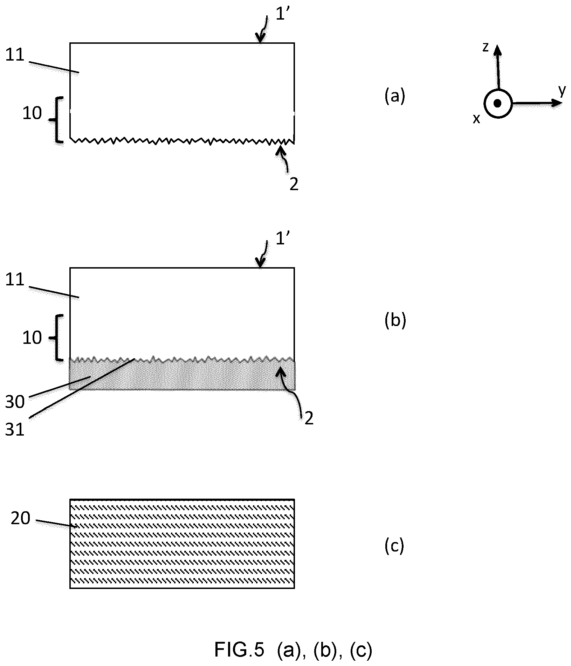

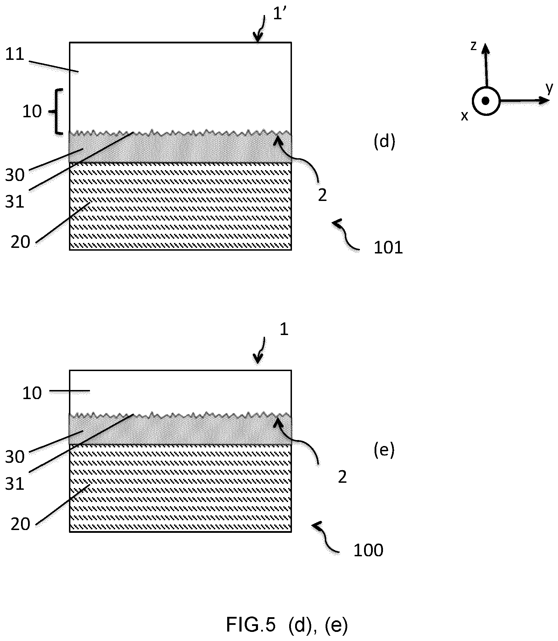

L'invention concerne également un procédé de fabrication d'une structure hybride 100 pour dispositif à ondes acoustiques de surface 200, qui va être décrit en référence aux figures 5 à 7.

Le procédé de fabrication comprend tout d'abord une étape de fourniture d'une couche utile 10 de matériau piézoélectrique comprenant une première face 1 et une deuxième face 2 présentant une rugosité déterminée. Ladite rugosité est définie par l'amplitude maximale crête-à-creux, mesurée par exemple par profilométrie mécanique ou optique, sur des profils de mesure de l'ordre de 50 à 500 µm ou des surfaces de mesure de l'ordre de 50x50 à 500x500 µm2. Avantageusement, la rugosité déterminée est supérieure à 0,3 µm, voire supérieure ou égale à 0,5 µm, voire encore supérieure à 1 µm. Préférentiellement, elle est même comprise entre 0,3 et 5 µm .

De manière également avantageusement, la densité spectrale de la rugosité de l'interface fonctionnelle 31 couvre tout ou partie de la bande spectrale de longueurs d'onde des ondes parasites que l'on cherche à éliminer. Préférentiellement, la rugosité déterminée présente des longueurs d'ondes spatiales et une amplitude au moins égales à un quart des longueurs d'ondes parasites.

La rugosité déterminée de l'interface fonctionnelle 31 pourra donc être adaptée en amplitude et potentiellement en densité spectrale en fonction de la fréquence des ondes acoustiques du dispositif SAW qui sera fabriqué sur la structure hybride 100, pour son aptitude à diffuser efficacement les ondes acoustiques susceptibles de se propager dans la couche utile 10.

La rugosité déterminée peut être réalisée sur la deuxième face 2 par des techniques de rodage mécanique, polissage mécano-chimique, gravure chimique humide ou sèche, ou une combinaison de ces différentes techniques. L'objectif est de créer sur la deuxième face 2 de la couche utile 10 une rugosité uniforme sur toute la face, d'amplitude déterminée. A titre d'exemple, une telle rugosité peut être obtenue par les traitements typiques de faces arrières dépolies des plaquettes (tantalate de lithium, niobate de lithium...) utilisées dans l'industrie du semi-conducteur.

Comme énoncé précédemment et sans que cela soit limitatif, la couche utile 10 comprend un matériau piézoélectrique choisi parmi le tantalate de lithium (LiTaO3), le niobate de lithium (LiNbO3), le quartz, l'oxyde de zinc (ZnO), le nitrure d'aluminium (AlN).

Selon un mode de réalisation avantageux, la couche utile 10 est comprise dans un substrat donneur 11, présentant une deuxième face 2 de rugosité déterminée et une première face 1' (figure 5a).

Le procédé de fabrication selon l'invention comprend également une étape de formation d'une couche de piégeage 30 sur la deuxième face 2 de la couche utile 10, ou du substrat donneur 11 (figure 5b). L'interface entre la couche de piégeage 30 et la couche utile 10 (ou le substrat donneur 11) forme une interface fonctionnelle 31 de rugosité déterminée. Avantageusement, la couche de piégeage 30 est formée d'un matériau choisi parmi le silicium amorphe, le silicium poly-cristallin, le germanium amorphe ou poly-cristallin. La couche de piégeage 30 peut être élaborée par des techniques connues de dépôt chimique (PECVD, LPCVD, etc.).

La couche de piégeage 30 présente typiquement une épaisseur comprise entre quelques dizaines de nm et quelques µm, voire quelques dizaines de µm

Avantageusement, l'étape de formation de la couche de piégeage 30 comprend une étape de lissage de la surface libre de la couche de piégeage 30, consistant par exemple en un polissage mécano-chimique, une gravure lissante par plasma ou attaque chimique humide. Préférentiellement, la surface libre de la couche de piégeage 30 présentera une faible rugosité (typiquement <0,5nm RMS, mesurée par microscopie à force atomique) et une bonne planéité, en vue d'une étape ultérieure d'assemblage.

Le procédé de fabrication comprend également une étape de fourniture d'un substrat support 20 (figure 5c) présentant un coefficient de dilatation thermique inférieur à celui de la couche utile 10. Avantageusement, le substrat support 20 est en silicium, ce matériau étant largement disponible et compatible avec l'industrie du semi-conducteur. Alternativement, il pourra également être en germanium ou autre matériau compatible avec les étapes subséquentes du procédé et de l'élaboration du dispositif à ondes acoustiques de surface.

Le procédé de fabrication comprend ensuite une étape d'assemblage pour disposer le substrat donneur 11 (ou la couche utile 10) sur le substrat support 20 (figure 5d). L'étape d'assemblage s'opère entre la couche de piégeage 30 et le substrat support 20, c'est pourquoi les propriétés de surface de la couche de piégeage 30 et du substrat support 20 doivent être correctement contrôlées. Avantageusement, l'étape d'assemblage comprend un collage direct par adhésion moléculaire : cette technique de collage est préférée en ce qu'elle ne requiert pas l'utilisation d'une couche de matière additionnelle.

Alternativement, l'étape d'assemblage pourra comprendre un collage adhésif, un collage métallique, un collage anodique, ou toute autre sorte de collage connu de l'état de l'art et compatible avec l'application visée.

Avantageusement, l'étape d'assemblage comprend, préalablement au collage, une séquence de nettoyage pour assurer un bon niveau de propreté (retrait des particules, des contaminants hydrocarbures et métalliques, etc.) aux surfaces avant le collage.

Selon une variante du procédé, une couche de même nature que la couche de piégeage 30 pourra être déposée sur le substrat support 20 préalablement à l'étape d'assemblage, et sera préparée en vue d'être collée sur la couche de piégeage 30. En effet, selon la nature de la couche de piégeage 30 et celle du substrat support 20, il peut être avantageux, notamment dans le cas d'un collage direct par adhésion moléculaire, de former une interface de collage entre deux matériaux de même nature.

Pour consolider l'interface de collage, la structure hybride collée 101 peut être soumise à un traitement thermique. Il est à noter que les matériaux du substrat donneur 11 (ou de la couche utile 10) et du substrat support 20 présentent des coefficients de dilatation thermique très différents, le traitement thermique appliqué doit donc rester à une température inférieure à la température d'endommagement ou de casse de la structure collée 101. La gamme de température est typiquement comprise entre quelques dizaines de degrés et 500°C.

Dans le cas illustré sur les figures 5a à 5e, où la couche utile 10 est comprise dans un substrat donneur 11, le procédé de fabrication comprend en outre une étape d'amincissement du substrat donneur 11 (figure 5e) pour former la couche utile 10 et la première face 1, sur laquelle les dispositifs à ondes acoustiques de surface seront élaborés.

Cette étape d'amincissement peut être faite à partir des différentes techniques connues de l'art antérieur, notamment :
- le procédé Smart-Cut^{®}, particulièrement adapté à la formation de couches utiles très fines (typiquement d'épaisseur inférieure ou égale à 1 µm) : il est basé sur une implantation d'espèces gazeuses dans le substrat donneur 11, au niveau de sa deuxième face 2, préalablement à l'étape d'assemblage, pour former un plan enterré fragilisé ; après assemblage, le substrat donneur 11 se séparera le long du plan fragilisé, pour ne laisser solidaire du substrat support 20 que la couche utile 10.
- les procédés d'amincissement mécano-chimiques, incluant le rodage mécanique, le polissage mécano-chimique et la gravure chimique, adaptés à la formation de couches utiles d'épaisseurs comprises entre quelques µm et quelques dizaines, voire centaines de µm .

Au terme de ce procédé de fabrication, on obtient une structure hybride 100 selon l'invention (figure 5e).

L'invention concerne un autre procédé de fabrication d'une structure hybride 100 pour un dispositif à ondes acoustiques de surface comprenant tout d'abord une étape de fourniture d'une couche utile 10 de matériau piézoélectrique comprenant une première face 1 et une deuxième face 2.

Comme énoncé précédemment et sans que cela soit limitatif, la couche utile 10 comprend un matériau piézoélectrique choisi parmi le tantalate de lithium (LiTaO3), le niobate de lithium (LiNbO3), le quartz, l'oxyde de zinc (ZnO), le nitrure d'aluminium (AlN).

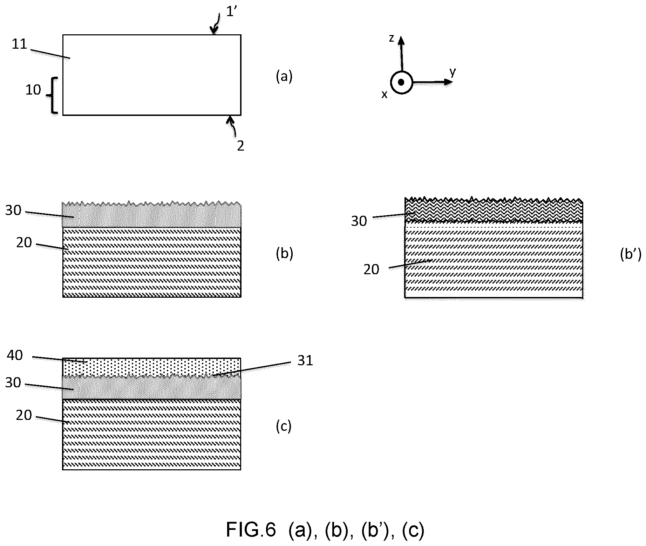

Selon un mode de réalisation avantageux, la couche utile 10 est comprise dans un substrat donneur 11, présentant une deuxième face 2 et une première face 1' (figure 6a).

Le procédé de fabrication comprend également une étape de fourniture d'un substrat support 20 présentant un coefficient de dilatation thermique inférieur à celui de la couche utile 10. Avantageusement, le substrat support 20 est en silicium, ce matériau étant largement disponible et compatible avec l'industrie du semi-conducteur. Comme évoqué précédemment, il pourra alternativement être formé ou comprendre du germanium ou autre matériau compatible avec les étapes subséquentes de fabrication.

Le procédé de fabrication comprend également une étape de formation d'une couche de piégeage 30 sur le substrat support 20 (figure 6b). La couche de piégeage 30 présente une rugosité déterminée.

Avantageusement, la couche de piégeage 30 est formée d'un matériau choisi parmi le silicium amorphe, le silicium poly-cristallin, le germanium amorphe ou poly-cristallin. Elle peut être élaborée par des techniques connues de dépôt chimique (CVD).

La couche de piégeage 30 pourra également être formée par une technique ou une combinaison de techniques parmi lesquelles :
- l'implantation d'ions dans une couche superficielle du substrat support 20 ; pour un substrat en silicium, une implantation par exemple d'ions d'argon, de silicium, d'azote, etc... pourra être effectuée pour générer une couche superficielle perturbée, apte à piéger des charges mobiles issues du substrat support 20 ;
- ou par la gravure et la structuration d'une couche superficielle du substrat support 20 ; par exemple, par gravure mécanique, chimique humide ou sèche, induisant une structuration de la surface, site privilégié de piégeage pour des charges mobiles issues du substrat support 20.

La couche de piégeage 30 peut avoir une épaisseur comprise entre quelques dizaines de nm et quelques µm, voire quelques dizaines de µm.

La rugosité de la surface libre de la couche de piégeage 30, après sa formation sur le substrat support 20, est définie par l'amplitude maximale crête-à-creux, mesurée par exemple par profilométrie mécanique ou optique, sur des profils de mesure de l'ordre de 50 à 500 µm ou des surfaces de mesure de l'ordre de 50x50 à 500x500 µm2. Avantageusement, la rugosité déterminée est supérieure à 0,3 µm, voire supérieure ou égale à 0,5 micron, voire encore supérieure ou égale à 1 µm. Elle est préférentiellement comprise entre 0,3 et 5 µm.

De manière également avantageusement, la densité spectrale de la rugosité de l'interface fonctionnelle 31 couvre tout ou partie de la bande spectrale de longueurs d'onde des ondes parasites que l'on cherche à éliminer. Préférentiellement, la rugosité déterminée présente des longueurs d'ondes spatiales et une amplitude au moins égales à un quart des longueurs d'ondes parasites.

La rugosité déterminée peut être obtenue sur la surface libre de la couche de piégeage 30, soit directement après dépôt de la couche, soit par des techniques de rodage mécanique, polissage mécano-chimique, gravure chimique humide ou sèche, ou une combinaison de ces différentes techniques. L'objectif est de créer sur la surface libre de la couche de piégeage 30 une rugosité uniforme d'amplitude déterminée. A titre d'exemple, une telle rugosité peut être obtenue par les traitements de type « acid etch » ou « alcali etch » réalisés pour le traitement des faces arrières dépolies des plaquettes de silicium utilisées dans l'industrie du semi-conducteur. Selon un autre exemple, la rugosité déterminée de la surface libre de la couche de piégeage 30 peut être obtenue par rodage mécanique (typiquement avec une roue diamantée de grain 2000) puis gravure chimique humide (typiquement par TMAH) de la surface du substrat support 20, avant dépôt d'une couche de piégeage 30 en silicium poly-cristallin ; la surface libre de la couche de piégeage 30 après dépôt sur le substrat support 20 présente alors la rugosité déterminée de l'ordre de 0,5 µm crête-à-creux (figure 6b') .

Le procédé de fabrication comprend ensuite une étape de formation d'une première couche intercalaire 40 sur la couche de piégeage 30. L'interface entre la couche de piégeage 30 et la première couche intercalaire 40 forme l'interface fonctionnelle 31 de rugosité déterminée. La première couche intercalaire 40 peut comprendre un matériau choisi parmi l'oxyde de silicium, le nitrure de silicium, l'oxynitrure de silicium, ou un matériau de même nature que la couche utile 10. Elle pourra être élaborée par dépôt chimique. Avantageusement, une étape de lissage (par exemple, polissage mécano-chimique) est effectuée sur la surface libre de la première couche intercalaire 40, en vue de l'étape ultérieure d'assemblage sur le substrat donneur 11 (ou la couche utile 10). Cette option est particulièrement adaptée lorsque l'étape subséquente d'assemblage comprend un collage par adhésion moléculaire.

La première couche intercalaire 40 peut également comprendre un matériau de type polymère, qui pourra, par exemple, être déposé par centrifugation. L'avantage de ce type de matériau est que le lissage peut s'effectuer directement pendant le dépôt. Cette option est notamment adaptée lorsque l'étape subséquente d'assemblage comprend un collage adhésif.

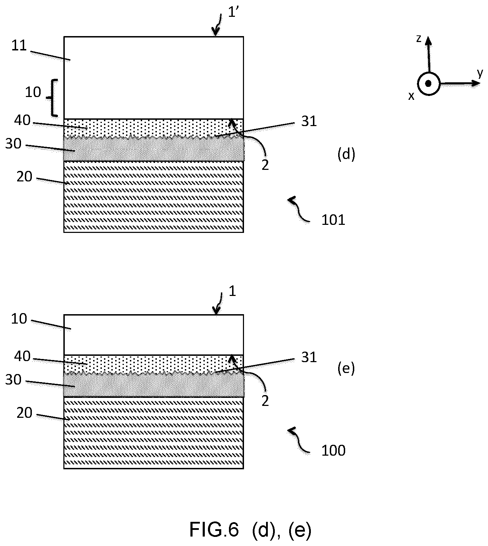

Le procédé de fabrication comprend enfin une étape d'assemblage permettant de disposer le substrat donneur 11 (ou la couche utile 10) sur le substrat support 20 ; en particulier, l'assemblage s'opère entre la première couche intercalaire 40 et la deuxième face 2 du substrat donneur 11 (figure 6d).

Avantageusement, l'étape d'assemblage comprend un collage direct par adhésion moléculaire : cette technique de collage est avantageuse en ce qu'elle ne requiert pas l'utilisation d'une couche de matière additionnelle. Alternativement, l'étape d'assemblage pourra comprendre un collage adhésif, un collage métallique, un collage anodique, ou toute autre sorte de collage connu de l'état de l'art et compatible avec l'application visée. Avantageusement, l'étape d'assemblage comprend, préalablement au collage, une séquence de nettoyage pour assurer un bon niveau de propreté (retrait des particules, des contaminants hydrocarbures et métalliques) aux surfaces avant le collage.

Pour consolider l'interface de collage, la structure hybride collée 101 peut être soumise à un traitement thermique, à basse ou moyenne température pour éviter d'endommager l'hétéro-structure : typiquement, entre quelques dizaines de degrés et 500°C.

Dans le cas, illustré sur les figure 6a à 6e, où la couche utile 10 est comprise dans un substrat donneur 11, le procédé de fabrication comprend en outre une étape d'amincissement du substrat donneur 11 (figure 6e) pour former la couche utile 10 et la première face 1, sur laquelle les dispositifs à ondes acoustiques de surface seront élaborés.

Cette étape d'amincissement peut être faite à partir des différentes techniques connues de l'art antérieur, comme précédemment évoqué.

Au terme de ce procédé de fabrication, on obtient une structure hybride 100 selon l'invention (figure 6e).

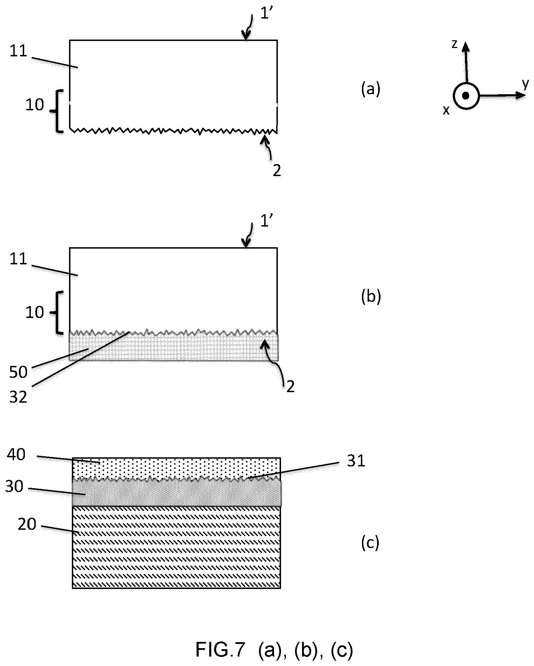

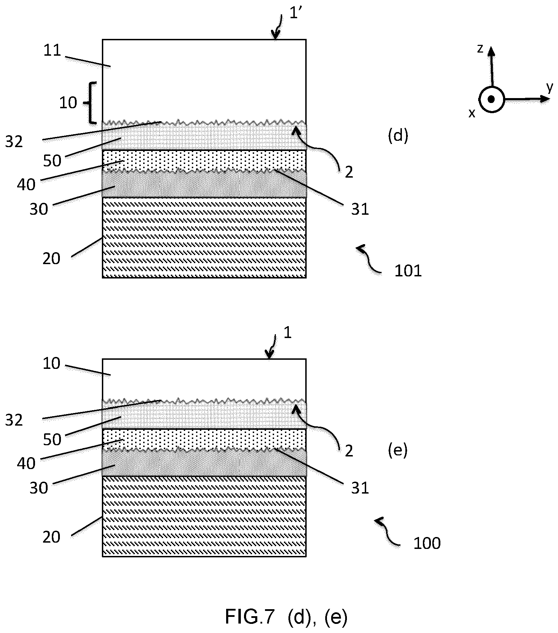

Selon une variante du procédé de fabrication précité, illustrée sur les figures 7a à 7e, la deuxième face 2 de la couche utile 10 (ou du substrat donneur 11, dans le cas où la couche utile 10 est comprise dans un substrat donneur) présente une deuxième rugosité déterminée (figure 7a). L'amplitude crête-à-creux de la deuxième rugosité déterminée est avantageusement supérieure à 0,1 µm.

Cette variante du procédé de fabrication comprend une étape de formation d'une deuxième couche intercalaire 50 sur la deuxième face 2 de la couche utile 10 ou du substrat donneur 11, comme illustré sur la figure 7b. La deuxième couche intercalaire 50 peut comprendre un matériau ou un empilement de matériaux choisis parmi l'oxyde de silicium, le nitrure de silicium, l'oxynitrure de silicium. La deuxième couche intercalaire 50 peut également comprendre un matériau de même nature que celui constituant la couche utile 10, pour limiter les problématiques liées aux différences de dilatation thermique.

L'interface entre la couche utile 10 et la deuxième couche intercalaire 50 forme une deuxième interface fonctionnelle 32. Avantageusement, l'étape de formation de la deuxième couche intercalaire 50 comprend une étape de lissage de sa surface libre, en vue de l'étape d'assemblage.

Préalablement à l'étape d'assemblage, la couche de piégeage 30, présentant une première rugosité déterminée, est formée sur le substrat support 20. Puis, la première couche intercalaire 40 est formée sur la couche de piégeage 30 (figure 7c). L'interface entre ces deux couches forme l'interface fonctionnelle 31 de rugosité déterminée.

Optionnellement, les première 40 et deuxième 50 couches intercalaires pourront être composées du même matériau.

Cette variante du procédé de fabrication comprend ensuite l'assemblage des première 40 et deuxième 50 couches intercalaires, avantageusement par collage direct, sans que cela soit pris de manière limitative.

Un traitement thermique peut optionnellement être effectué pour consolider l'interface de collage de la structure collée 101.

Lorsque la couche utile 10 est comprise dans un substrat donneur 11, une étape d'amincissement, telle que déjà énoncé précédemment, est réalisée, menant à l'obtention de la structure hybride 100 (figure 7e).

Bien entendu, l'invention n'est pas limitée aux modes de réalisation décrits et on peut y apporter des variantes de réalisation sans sortir du cadre de l'invention tel que défini par les revendications.

## Revendications

1. Structure hybride (100) pour dispositif à ondes acoustiques de surface comprenant une couche utile (10) de matériau piézoélectrique présentant une première face (1) libre et une deuxième face (2) disposée sur un substrat support (20) dont le coefficient de dilatation thermique est inférieur à celui de la couche utile (10), la structure hybride (100) étant **caractérisée en ce qu'**elle comprend :
• une couche de piégeage (30) interposée entre la couche utile (10) et le substrat support (20), la couche de piégeage (30) étant formée par implantation dans une couche superficielle du substrat support (20) ou par gravure et structuration de la couche superficielle du substrat support (20) ;
• au moins une interface fonctionnelle (31) de rugosité déterminée, entre la couche utile (10) et la couche de piégeage (30).

2. Structure hybride (100) pour dispositif à ondes acoustiques de surface selon l'une des revendications précédentes, dans laquelle la rugosité déterminée de l'interface fonctionnelle (31) présente une amplitude crête à creux supérieure à 0,3 µm.

3. Structure hybride (100) pour dispositif à ondes acoustiques de surface selon l'une des revendications 1 et 2, dans laquelle l'interface fonctionnelle (31) est formée par l'interface entre une première couche intercalaire (40), disposée sur la deuxième face (2) de la couche utile (10), et la couche de piégeage (30) ; la couche de piégeage (30) présentant la rugosité déterminée.

4. Structure hybride (100) pour dispositif à ondes acoustiques de surface selon la revendication précédente, dans laquelle la première couche intercalaire (40) comprend un matériau choisi parmi l'oxyde de silicium, le nitrure de silicium, l'oxynitrure de silicium, ou un matériau de même nature que celui constituant la couche utile (10).

5. Structure hybride (100) pour dispositif à ondes acoustiques de surface selon l'une des deux revendications précédentes, comprenant une deuxième interface fonctionnelle (32).

6. Structure hybride (100) pour dispositif à ondes acoustiques de surface selon la revendication précédente, dans laquelle la deuxième interface fonctionnelle (32) est formée par l'interface entre la couche utile (10) et une deuxième couche intercalaire (50) disposée sur la première couche intercalaire (40) ; la deuxième interface fonctionnelle (32) présentant une deuxième rugosité déterminée dont l'amplitude crête-à-creux est supérieure à 0,1 µm.

7. Structure hybride (100) pour dispositif à ondes acoustiques de surface selon la revendication précédente, dans laquelle la deuxième couche intercalaire (50) comprend un matériau choisi parmi l'oxyde de silicium, le nitrure de silicium, l'oxynitrure de silicium ou un matériau de même nature que celui constituant la couche utile (10).

8. Structure hybride (100) pour dispositif à ondes acoustiques de surface selon l'une des deux revendications précédentes, dans laquelle la première couche intercalaire (40) et la deuxième couche intercalaire (50) sont formées du même matériau.

9. Structure hybride (100) pour dispositif à ondes acoustiques de surface selon l'une des revendications précédentes, dans laquelle la couche utile (10) comprend un matériau piézoélectrique choisi parmi le tantalate de lithium (LiTaO₃), le niobate de lithium (LiNbO₃), le quartz, l'oxyde de zinc (ZnO), le nitrure d'aluminium (AlN).

10. Structure hybride (100) pour dispositif à ondes acoustiques de surface selon l'une des revendications précédentes, dans laquelle le substrat support est un substrat massif ou un substrat composite comprenant au moins une couche vierge ou comportant tout ou partie de composants micro-électroniques.

11. Dispositif à ondes acoustiques de surface (200) comprenant une structure hybride (100) selon l'une des revendications précédentes.

12. Procédé de fabrication d'une structure hybride (100) pour un dispositif à ondes acoustiques de surface comprenant :
• Une étape de fourniture d'une couche utile (10) de matériau piézoélectrique comprenant une première face (1) et une deuxième face (2) ;
• Une étape de fourniture d'un substrat support (20) présentant un coefficient de dilatation thermique inférieur à celui de la couche utile (10) ;
• Une étape d'assemblage pour disposer la couche utile (10) sur le substrat support (20) ;
Le procédé étant **caractérisé en ce qu'**il comprend, préalablement à l'étape d'assemblage :
• Une étape de formation d'une couche de piégeage (30), présentant une rugosité déterminée, sur le substrat support (20), la couche de piégeage (30) étant formée par implantation dans une couche superficielle du substrat support (20) ou par gravure et structuration de la couche superficielle du substrat support (20) ;
• Une étape de formation d'une première couche intercalaire (40) sur la couche de piégeage (30), l'interface entre la couche de piégeage (30) et la première couche intercalaire (40) formant une interface fonctionnelle (31) de rugosité déterminée.

13. Procédé de fabrication d'une structure hybride (100) selon la revendication précédente, dans lequel l'étape d'assemblage s'opère entre la première couche intercalaire (40) et la deuxième face (2) de la couche utile (10).

14. Procédé de fabrication d'une structure hybride (100) selon la revendication 12, comprenant, préalablement à l'étape d'assemblage, une étape de formation d'une deuxième couche intercalaire (50) sur la deuxième face (2) de la couche utile (10) qui présente une deuxième rugosité déterminée, l'étape d'assemblage s'opérant entre la première couche intercalaire (40) et la deuxième couche intercalaire (50) ; l'interface entre la couche utile (10) et la deuxième couche intercalaire (50) formant une deuxième interface fonctionnelle (32).

## Patentansprüche

1. Hybridstruktur (100) für eine akustische Oberflächenwellenvorrichtung, umfassend eine Nutzschicht (10) aus piezoelektrischem Material, die eine erste freie Seite (1) und eine zweite Seite (2) aufweist, die auf einem Trägersubstrat (20) angeordnet ist, dessen Wärmeausdehnungskoeffizient kleiner als der der Nutzschicht (10) ist, wobei die Hybridstruktur (100) **dadurch gekennzeichnet ist, dass** sie Folgendes umfasst:
• eine zwischen der Nutzschicht (10) und dem Trägersubstrat (20) angeordnete Fangschicht (30), wobei die Fangschicht (30) durch Implantation in eine Oberflächenschicht des Trägersubstrats (20) oder durch Ätzen und Strukturieren der Oberflächenschicht des Trägersubstrats (20) ausgebildet wird;
• mindestens eine funktionelle Grenzfläche (31) mit einer bestimmten Rauhigkeit zwischen der Nutzschicht (10) und der Fangschicht (30).

2. Hybridstruktur (100) für eine akustische Oberflächenwellenvorrichtung nach einem der vorhergehenden Ansprüche, wobei die bestimmte Rauhigkeit der funktionellen Grenzfläche (31) eine Spitze-Tal-Amplitude von größer als 0,3 µm aufweist.

3. Hybridstruktur (100) für eine akustische Oberflächenwellenvorrichtung nach einem der Ansprüche 1 und 2, wobei die funktionelle Grenzfläche (31) durch die Grenzfläche zwischen einer auf der zweiten Seite (2) der Nutzschicht (10) angeordneten ersten Zwischenschicht (40) und der Fangschicht (30) gebildet wird; wobei die Fangschicht (30) die bestimmte Rauhigkeit aufweist.

4. Hybridstruktur (100) für eine akustische Oberflächenwellenvorrichtung nach dem vorhergehenden Anspruch, wobei die erste Zwischenschicht (40) ein Material umfasst, das ausgewählt ist aus Siliciumoxid, Siliciumnitrid, Siliciumoxynitrid oder einem Material der gleichen Art wie das, das die Nutzschicht (10) bildet.

5. Hybridstruktur (100) für eine akustische Oberflächenwellenvorrichtung nach einem der beiden vorhergehenden Ansprüche, die eine zweite funktionelle Grenzfläche (32) umfasst.

6. Hybridstruktur (100) für eine akustische Oberflächenwellenvorrichtung nach dem vorhergehenden Anspruch, wobei die zweite funktionelle Grenzfläche (32) durch die Grenzfläche zwischen der Nutzschicht (10) und einer zweiten Zwischenschicht (50) gebildet wird, die auf der ersten Zwischenschicht (40) angeordnet ist; wobei die zweite funktionelle Grenzfläche (32) eine zweite bestimmte Rauhigkeit aufweist, deren Spitze-Tal-Amplitude größer als 0,1 µm ist.

7. Hybridstruktur (100) für eine akustische Oberflächenwellenvorrichtung nach dem vorhergehenden Anspruch, wobei die zweite Zwischenschicht (50) ein Material umfasst, das ausgewählt ist aus Siliciumoxid, Siliciumnitrid, Siliciumoxynitrid oder einem ähnlichen Material wie das, das die Nutzschicht (10) bildet.

8. Hybridstruktur (100) für eine akustische Oberflächenwellenvorrichtung nach einem der beiden vorhergehenden Ansprüche, wobei die erste Zwischenschicht (40) und die zweite Zwischenschicht (50) aus dem gleichen Material gebildet sind.

9. Hybridstruktur (100) für eine akustische Oberflächenwellenvorrichtung nach einem der vorhergehenden Ansprüche, wobei die Nutzschicht (10) ein piezoelektrisches Material umfasst, das ausgewählt ist aus Lithiumtantalat (LiTaO3), Lithiumniobat (LiNbO3), Quarz, Zinkoxid (ZnO), Aluminiumnitrid (AIN).

10. Hybridstruktur (100) für eine akustische Oberflächenwellenvorrichtung nach einem der vorhergehenden Ansprüche, wobei das Trägersubstrat ein massives Substrat oder ein Verbundsubstrat ist, das mindestens eine unbestückte Schicht oder die Gesamtheit oder einen Teil der mikroelektronischen Bauteile umfasst.

11. Akustische Oberflächenwellenvorrichtung (200), umfassend eine Hybridstruktur (100) nach einem der vorhergehenden Ansprüche.

12. Verfahren zum Herstellen einer Hybridstruktur (100) für eine akustische Oberflächenwellenvorrichtung, umfassend:
• einen Schritt des Bereitstellens einer Nutzschicht (10) aus piezoelektrischem Material, umfassend eine erste Seite (1) und eine zweite Seite (2);
• einen Schritt des Bereitstellens eines Trägersubstrats (20), das einen kleineren Wärmeausdehnungskoeffizienten als die Nutzschicht (10) aufweist;
• einen Schritt des Verbindens, um die Nutzschicht (10) auf das Trägersubstrat (20) aufzubringen;
wobei das Verfahren **dadurch gekennzeichnet ist, dass** es vor dem Verbindungsschritt Folgendes umfasst:
• einen Schritt des Ausbildens einer eine bestimmte Rauhigkeit aufweisenden Fangschicht (30) auf dem Trägersubstrat (20), wobei die Fangschicht (30) durch Implantation in eine Oberflächenschicht des Trägersubstrats (20) oder durch Ätzen und Strukturieren der Oberflächenschicht des Trägersubstrats (20) ausgebildet wird;
• einen Schritt des Ausbildens einer ersten Zwischenschicht (40) auf der Fangschicht (30), wobei die Grenzfläche zwischen der Fangschicht (30) und der ersten Zwischenschicht (40) eine funktionelle Grenzfläche (31) mit einer bestimmten Rauhigkeit bildet.

13. Verfahren zum Herstellen einer Hybridstruktur (100) nach dem vorhergehenden Anspruch, wobei der Verbindungsschritt zwischen der ersten Zwischenschicht (40) und der zweiten Seite (2) der Nutzschicht (10) erfolgt.

14. Verfahren zum Herstellen einer Hybridstruktur (100) nach Anspruch 12, umfassend, vor dem Verbindungsschritt, einen Schritt des Ausbildens einer zweiten Zwischenschicht (50) auf der zweiten Seite (2) der Nutzschicht (10), die eine zweite bestimmte Rauhigkeit aufweist, wobei der Verbindungsschritt zwischen der ersten Zwischenschicht (40) und der zweiten Zwischenschicht (50) erfolgt; wobei die Grenzfläche zwischen der Nutzschicht (10) und der zweiten Zwischenschicht (50) eine zweite funktionale Grenzfläche (32) bildet.

## Claims

1. Hybrid structure (100) for a surface acoustic wave device, comprising a useful layer (10) of piezoelectric material having a free first face (1) and a second face (2) that is arranged on a support substrate (20) having a coefficient of thermal expansion lower than that of the useful layer (10), the hybrid structure (100) being **characterized in that** it comprises:
• a trapping layer (30) interposed between the useful layer (10) and the support substrate (20), the trapping layer (30) being formed by implantation in a surface layer of the support substrate (20) or by etching and structuring of the surface layer of the support substrate (20);
• at least one functional interface (31) of a predetermined roughness, between the useful layer (10) and the trapping layer (30).

2. Hybrid structure (100) for a surface acoustic wave device according to one of the preceding claims, wherein the predetermined roughness of the functional interface (31) has a peak-to-valley amplitude greater than 0.3 µm.

3. Hybrid structure (100) for a surface acoustic wave device according to one of claims 1 and 2, wherein the functional interface (31) is formed by the interface between a first intermediate layer (40), arranged on the second face (2) of the useful layer (10), and the trapping layer (30), the trapping layer (30) having the predetermined roughness.

4. Hybrid structure (100) for a surface acoustic wave device according to the preceding claim, wherein the first intermediate layer (40) comprises a material selected from silicon oxide, silicon nitride, silicon oxynitride, or a material of the same kind as that constituting the useful layer (10).

5. Hybrid structure (100) for a surface acoustic wave device according to either of the two preceding claims, comprising a second functional interface (32).

6. Hybrid structure (100) for a surface acoustic wave device according to the preceding claim, wherein the second functional interface (32) is formed by the interface between the useful layer (10) and a second intermediate layer (50) arranged on the first intermediate layer (40), the second functional interface (32) having a second predetermined roughness of which the peak-to-valley amplitude is greater than 0.1 µm.

7. Hybrid structure (100) for a surface acoustic wave device according to the preceding claim, wherein the second intermediate layer (50) comprises a material selected from silicon oxide, silicon nitride, silicon oxynitride or a material of the same kind as that constituting the useful layer (10).

8. Hybrid structure (100) for a surface acoustic wave device according to either of the two preceding claims, wherein the first intermediate layer (40) and the second intermediate layer (50) are formed of the same material.

9. Hybrid structure (100) for a surface acoustic wave device according to one of the preceding claims, wherein the useful layer (10) comprises a piezoelectric material selected from lithium tantalate (LiTaO3), lithium niobate (LiNbO3), quartz, zinc oxide (ZnO) or aluminum nitride (AIN).

10. Hybrid structure (100) for a surface acoustic wave device according to one of the preceding claims, wherein the support substrate is a solid substrate or a composite substrate comprising at least one blank layer or at least partially comprising microelectronic components.

11. Surface acoustic wave device (200) comprising a hybrid structure (100) according to one of the preceding claims.

12. Method for producing a hybrid structure (100) for a surface acoustic wave device, comprising:
• a step of providing a useful layer (10) made of piezoelectric material and comprising a first face (1) and a second face (2);
• a step of providing a support substrate (20) having a coefficient of thermal expansion lower than that of the useful layer (10);
• a joining step for arranging the useful layer (10) on the support substrate (20); the method being **characterized in that** it comprises, prior to the joining step:
• a step of forming a trapping layer (30), having a predetermined roughness, on the support substrate (20), the trapping layer (30) being formed by implantation in a surface layer of the support substrate (20) or by etching and structuring of the surface layer of the support substrate (20);
• a step of forming a first intermediate layer (40) on the trapping layer (30), the interface between the trapping layer (30) and the first intermediate layer (40) forming a functional interface (31) of a predetermined roughness.

13. Method for producing a hybrid structure (100) according to the preceding claim, wherein the joining step takes place between the first intermediate layer (40) and the second face (2) of the useful layer (10).

14. Method for producing a hybrid structure (100) according to claim 12, comprising, prior to the joining step, a step of forming a second intermediate layer (50) on the second face (2) of the useful layer (10) which has a second predetermined roughness, the joining step taking place between the first intermediate layer (40) and the second intermediate layer (50), the interface between the useful layer (10) and the second intermediate layer (50) forming a second functional interface (32).
